# EUROPÄISCHE PATENTSCHRIFT

(11) **EP 2 715 374 B1**
(45) Veröffentlichungstag und Bekanntmachung des Hinweises auf die Patenterteilung: **20.07.2016**
(21) Anmeldenummer: 12720411.3
(22) Anmeldetag: 24.04.2012
(51) Int. Cl.: G01R 15/18

(54) **STROMMESSUMFORMER**
CURRENT TRANSFORMER
CONVERTISSEUR DE MESURE DE COURANT

(30) Priorität: 23.05.2011 DE 102011102978
(43) Veröffentlichungstag der Anmeldung: 09.04.2014
(73) Patentinhaber: Phoenix Contact GmbH & Co. KG, 32825 Blomberg (DE)
(72) Erfinder: THÖRNER, Carsten, 49324 Melle (DE); LEIFER, Christoph, 33014 Bad Driburg (DE)
(74) Vertreter: Blumbach Zinngrebe
(86) Internationale Anmeldenummer: PCT/EP2012/001749
(87) Internationale Veröffentlichungsnummer: WO 2012/159698

(56) Entgegenhaltungen:
- EP-A1- 0 606 181
- EP-A1- 0 999 565
- WO-A1-2006/122415
- WO-A1-2010/042442
- DE-A1- 4 331 265
- US-A- 3 725 832
- US-A- 4 283 677
- US-A- 4 646 006
- US-A- 5 180 972

## Beschreibung

### Gebiet der Erfindung

Die Erfindung betrifft einen Strommessumformer sowie ein Verfahren zum Messen des durch ein elektrisches Kabel fließenden Stroms.

### Hintergrund der Erfindung

Der Betrag des durch ein elektrisches Kabel fließenden Stroms ist für die Verwendung eines Kabels und für den Betrieb von daran angeschlossenen Geräten eine wichtige Kenngröße. Zum Einen lässt sich aus der gemessenen Größe auf die durch das Kabel übertragene Leistung schließen, zum Anderen erfüllt eine solche Messung auch einen Sicherheitsaspekt. So lassen sich mittels der Strommessung Leistungsgrenzen überwachen, deren Überschreitung beispielsweise das Kabel selbst oder ein an das Kabel angeschlossenes Gerät überlasten könnten. Schließlich bestimmen Kabelquerschnitt und Zusammensetzung über die vom Kabel aufnehmbare Leistung.

Strommessungen als solche sind auch für ein von einem elektrischen Strom durchflossenen Kabel bekannt. So gibt beispielsweise das Dokument DE 689 09 847 T2 einen elektrischen Messumformer mit einer Spule, die um den elektrischen Leiter herum angeordnet ist, wobei der Leiter mittig durch die Spule geführt wird.

Prinzipiell kann man Strommessverfahren für ein elektrisches Kabel unterscheiden in solche Messverfahren, die ein elektrisches Messbauteil in dem elektrischen Leiter benötigen, und solche Messverfahren, die aus einem einen elektrischen Leiter umgebenden elektrischen oder magnetischen Feld auf den das elektrische Kabel durchfließenden elektrischen Strom rückschließen. Ein solches Bauteil, welches beispielsweise in das elektrische Kabel einzusetzen ist, ist ein Shunt-Widerstand.

Messverfahren, die ohne ein solches einzusetzende Bauteil auskommen, messen dagegen induktiv.

Strommessumformer, wie sie aus dem Stand der Technik bekannt sind, sind in der Regel auf das elektrische Kabel aufzuschieben. Hierdurch umschließt ein induktives Bauteil das elektrische Kabel und ermöglicht dadurch eine Messung mittels des Strommessumformers. Das präzise Anbringen eines bekannten Strommessumformers an einer gewünschten Stelle erweist sich als schwierig. Das nachträgliche Anbringen an ein bestehendes, bereits verlegtes Kabel, oder der einfache Austausch eines Strommessumformers ist überdies in der Regel nicht möglich.

Aus der DE 43 31 265 A1 geht ein Stromwandler für Hochspannungsleiter hervor, der aufgesetzt werden kann, ohne dass hierzu die Spannung abgeschaltet werden müsste.

US 5,180,972 zeigt einen Stromüberwacher zum temporären Aufsetzen auf ein Kabel. Eine hierzu ähnliche Anordnung geht auch aus US 4,646,006 hervor.

US 3,725,832 zeigt einen öffenbaren Magnetkern bestehend aus einer Vielzahl von Lamellen. Eine ähnliche Anordnung geht auch aus EP 0 999 565 A1 hervor.

Bestehende Lösungen, um ein nachträgliches Anbringen eines Strommessumformers an ein elektrisches Kabel zu ermöglichen, weisen keinen kreisförmig geschlossenen Ring auf, der um das elektrische Kabel ringförmig geschlossen angeordnet ist. Auch das Einführen des elektrischen Kabels in die Vorrichtung gestaltet sich schwierig.

### Allgemeine Beschreibung der Erfindung

Die Erfindung hat sich daher die Aufgabe gestellt, einen Strommessumformer bereitzustellen, welcher die genannten Probleme mindert oder löst.

Eine weitere Aufgabe der Erfindung ist es, eine einfache Montage des Strommessumformers an ein bereits verlegtes elektrisches Kabel zu ermöglichen.

Noch eine Aufgabe der Erfindung ist es, einen Strommessumformer bereitzustellen, welcher eine verbesserte Bündelung des magnetischen Flusses aufweist.

Die Aufgabe der Erfindung wird durch den Gegenstand der unabhängigen Ansprüche gelöst. Vorteilhafte Weiterbildungen der Erfindung sind in den Unteransprüchen definiert.

Erfindungsgemäß ist ein Strommessumformer zum Messen des durch ein elektrisches Kabel fließenden Stroms mit einem Sondenring versehen. Der Sondenring weist im Inneren einen Ringkern auf, mittels welchem eine Bündelung des um das stromdurchflossene elektrische Kabel herrschenden Magnetfelds ermöglicht wird. Durch die Bündelung des Magnetfelds in dem Ringkern wird eine Erhöhung der Magnetflussdichte erreicht, was die Messgenauigkeit signifikant erhöht.

Vorteilhafterweise kann das elektrische Kabel radial von der Seite in den Sondenring eingeführt werden. Um eine Öffnung des Sondenrings zu ermöglichen, weist der Sondenring neben einem Basisringabschnitt auch einen beweglichen Ringabschnitt auf, wobei der bewegliche Ringabschnitt einen geöffneten und einen geschlossenen Zustand definiert.

Der Sondenring ist insbesondere ringförmig mit einer axialen Öffnung im Inneren des Sondenrings ausgebildet. In dem geöffneten Zustand des beweglichen Ringabschnitts ist eine radiale Kabeleinführöffnung freigegeben, so dass das elektrische Kabel radial in den inneren Bereich des Strommessumformers eingebracht werden kann. Insbesondere überführt das Andrücken des Kabels an den beweglichen Ringabschnitt des Sondenrings den beweglichen Ringabschnitt automatisch von dem geschlossenen in den geöffneten Zustand, beispielsweise über ein einfaches Aufschwenken. Es kann aber das Einbringen des elektrischen Kabels in den inneren Bereich des Sondenrings den beweglichen Ringabschnitt auch von dem geöffneten in den geschlossenen Zustand überführen, wenn beispielsweise der bewegliche Ringabschnitt vor dem Kabeleinbringen geöffnet wird, der bewegliche Ringabschnitt in dem geöffneten Zustand gehalten wird und das Einbringen des Kabels in den inneren Bereich des Sondenrings eine Schließbetätigung auslöst, die beispielsweise mittels einer Rückstellfeder bewirkt wird.

Auch eine Überführung vom geschlossenen in den geöffneten Zustand beim Einführen und eine automatische Überführung in den geschlossenen Zustand nach dem Einführen des Kabels ist erfindungsgemäß. Dies wird beispielsweise erreicht, indem das Aufdrücken des beweglichen Ringabschnitts eine Rückstellkraft auf den beweglichen Ringabschnitt ausübt und sobald das Kabel den beweglichen Ringabschnitt passiert hat der bewegliche Ringabschnitt automatisch in den geschlossenen Zustand rückgestellt wird.

Befindet sich in dem geschlossenen Zustand das elektrische Kabel im inneren Bereich des Sondenrings, ist die Strommessung an dem Kabel ermöglicht. Des Weiteren ergibt der geschlossene Zustand des beweglichen Ringabschnitts eine ringförmig geschlossene Anordnung um das elektrische Kabel herum, in welcher der Ringkern das Kabel umschließt und der Magnetfluss um das elektrische Kabel geschlossen ist.

Der erfindungsgemäße Strommessumformer umfasst weiterhin einen Sensor. Der Sensor ist ausgebildet, die durch den Sondenring gebündelte, und damit gleichermaßen verstärkte Magnetflussdichte zu erfassen, beispielsweise mittels eines Hall-Sensors oder eines Magnetoresistiven Sensors. Der Sondenring und der Sensor bilden damit gemeinsam eine Messeinheit. Vorteilhafterweise ist der Sensor direkt am oder im Ringkern angeordnet.

In dem Strommessumformer ist ferner eine Auswerteeinrichtung zur Erfassung der mit dem Sondenring und dem Sensor erhaltenen Stromwerte umfasst. Die Auswerteeinrichtung ist dazu ausgebildet, aus der mit dem Sondenring und dem Sensor detektierte Magnetflussdichte den durch das elektrische Kabel fließenden Strom zu berechnen.

In einer bevorzugten Ausführungsform umfasst der Strommessumformer ein Federelement, welches in dem geschlossenen Zustand den beweglichen Ringabschnitt gegen den Basisringabschnitt federnd vorspannt und somit in dem geschlossenen Zustand hält. Mittels Beaufschlagung einer radialen Druckkraft auf den beweglichen Ringabschnitt wird der bewegliche Ringabschnitt gegen die Federvorspannung geöffnet, er schließt selbsttätig, wenn das Kabel vollständig radial in den inneren Bereich des Sondenrings eingebracht ist und die Trennstelle im Sondenring wird geschlossen.

Die Trennstelle unterbricht auch den im Sondenring angeordneten Ringkern, wobei der Ringkern an den beiden durch die Trennstelle getrennten Teilabschnitte des Ringkerns dem jeweils anderen Teilabschnitt zugewandte Stirnseiten aufweist, welche flächig aufeinander liegen, wenn der Sondenring, und damit der Ringkern, im geschlossenen Zustand ist.

Die Vorspannung des beweglichen Ringabschnitts mittels eines Federelements unterstützt ein dichtes Anliegen des beweglichen Ringabschnitts an dem Basisringabschnitt, so dass eine Magnetfeldlücke vermieden werden kann.

In einer weiteren Ausführungsform weist der Strommessumformer einen in seinem inneren Bereich angeordneten Betätigungsabschnitt auf. Der bewegliche Ringabschnitt gibt im geöffneten Zustand des beweglichen Ringabschnitts die Kabeleinführöffnung frei und mittels Beaufschlagung einer radialen Druckkraft auf den Betätigungsabschnitt schließt der bewegliche Ringabschnitt selbsttätig, wenn das Kabel vollständig radial in den inneren Bereich des Sondenrings eingebracht ist.

Hierbei ist der Strommessumformer also sowohl im geöffneten als auch im geschlossenen Zustand selbsthaltend ausgebildet. Mit anderen Worten weist der Strommessumformer einen bistabilen Zustand auf, der ein Verharren des beweglichen Ringabschnitts sowohl im geöffneten als auch im geschlossenen Zustand ermöglicht. Beispielsweise lässt sich dies mit einem bistabilen Federelement erzielen.

Der Sondenring kann ein Scharnier umfassen, welches zwischen dem Basisringabschnitt und dem beweglichen Ringabschnitt angeordnet ist, derart, dass der bewegliche Ringabschnitt mittels des Scharniers quer zur Kabelachse schwenkbar gelagert ist.

Insbesondere ist das Scharnier derart ausgebildet, dass der bewegliche Ringabschnitt mittels des Scharniers quer zur Kabelachse nach innen schwenkbar gelagert ist. Diese Bauform ermöglicht das automatische Freigeben der Kabeleinführöffnung beim Andrücken eines elektrischen Kabels auf den beweglichen Ringabschnitt.

Der bewegliche Ringabschnitt kann auch entlang des Sondenringumfangs verschiebbar ausgebildet sein, wobei das Beaufschlagen einer radialen Druckkraft auf den beweglichen Ringabschnitt den beweglichen Ringabschnitt in die geöffnete Position verschiebt. Mittels des verschiebbar ausgebildeten Sondenrings kann ggfs. eine höhere Andruckkraft des beweglichen Ringabschnitts an den Basisringabschnitt erzeugt werden, da das dazu zu verwendende Federelement die Kraft, insbesondere die Rückstellkraft, in tangentialer Richtung zum Sondenring erzeugen kann.

In einer besonders bevorzugten Ausführungsform weist der Sondenring zwei symmetrisch zueinander ausgebildete bewegliche Ringabschnitte auf, wobei die beweglichen Ringabschnitte im geöffneten Zustand die radiale Kabeleinführöffnung zwischen den beweglichen Ringabschnitten freigeben. Diese Bauform kann auch das automatische Entnehmen des Kabels ermöglichen. Wird ein Scharnier verwendet, so ist dies insbesondere als in beide Richtungen klappbar ausgeführt. Neben dem leichteren Freigeben der radialen Kabeleinführöffnung mit einem Sondenring, der zwei bewegliche Ringabschnitte umfasst, ist in dieser Bauform das Einbringen eines elektrischen Kabels größeren Durchmessers ermöglicht. Schließlich lässt sich somit nahezu der gesamte innere Bereich des Strommessumformers von einem Kabel ausfüllen, und damit ggf. die Baugröße des Strommessumformers reduzieren.

Insbesondere ist bei zwei symmetrisch zueinander ausgebildeten beweglichen Ringabschnitten auch das automatische Entnehmen des Kabels aus dem inneren Bereich des Strommessumformers ermöglicht. Weisen die beweglichen Ringabschnitte Scharniere auf, so sind diese hierfür insbesondere in beide Richtungen klappbar ausgeführt.

Insbesondere weist ein solcher Strommessumformer zwei Federelemente auf, welche in dem geschlossenen Zustand die beweglichen Ringabschnitte gegeneinander federnd vorspannen, so dass mittels Beaufschlagung einer radialen Druckkraft auf die beweglichen Ringabschnitte die Kabeleinführöffnung freigegeben wird. Wenn das Kabel vollständig radial in den inneren Bereich des Strommessumformers eingebracht ist, wird der geschlossene Zustand automatisch eingenommen. Mit anderen Worten schnappen hierbei die beweglichen Ringabschnitte automatisch zu, sobald das Kabel die beweglichen Ringabschnitte passiert hat und diese nicht mehr durch das Kabel gegen die Federvorspannkraft aufgedrückt oder aufgehalten werden.

Die Federn können gewöhnliche Schraubenfedern sein. Die Federn sind vorzugsweise direkt in den Scharnieren integrierte Ringfedern.

Der Strommessumformer umfasst bevorzugt ein dielektrisches Gehäuse. Das Gehäuse kann aus einem Gehäusebasisabschnitt zur Beherbergung der Auswerteeinrichtung und des Sensors, sowie einer Umhäusung für den Ringkern, welcher zum Sondenring zugehörig ist, aufgebaut sein. Mit anderen Worten umfasst der Sondenring vorzugsweise eine Umhäusung und einen in der Umhäusung angeordneten Ringkern. Die Umhäusung und der Gehäusebasisabschnitt können gemeinsam einstückig geformt, beispielsweise vergossen, sein.

Das dielektrische Gehäuse kann mit Mitteln zum Befestigen des Gehäuses an einem äußeren Gegenstand ausgerüstet sein. Die Anordnung des Sensors in oder an dem Sondenring ist dabei unter ökonomischen bzw. messphysikalischen Gesichtspunkten zu wählen.

Der Sensor ist insbesondere als Hall-Sensor ausgeführt, welcher an einer Trennstelle des Ringkerns in den Ringkern eingebracht wird, so dass der den Hall-Sensor durchströmende magnetische Fluss gemessen wird. In diesem Fall fungiert der Ringkern als Hall-Sonde.

Der Ringkern ist aus suszeptiblem Material ausgeführt. Ein solches Material ist dazu geeignet, das das Kabel umgebende Feld zu führen und ggf. zu bündeln. Die Messung mit einem Sensor und einem Ringkern ermöglicht genauere Ergebnisse, als die Messung ohne einen solchen Ringkern.

In einer weiteren Ausführungsform ist der Sensor als magneto-resistiver Sensor ausgebildet, welcher direkt an dem Ringkern angeordnet und mit der Auswerteeinrichtung verbunden wird.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

### Kurzbeschreibung der Figuren

Es zeigen:
- Fig. 1: eine Ausführungsform des erfindungsgemäßen Strommessumformers mit einem Scharnier,
- Fig. 2: eine weitere Ausführungsform des Strommessumformers mit zwei beweglichen Ringabschnitten,
- Fig. 2a: Einbringvorgang eines Kabels in die Ausführungsform wie Fig. 2,
- Fig. 2b: Einbringvorgang eines Kabels in die Ausführungsform wie Fig. 2,
- Fig. 2c: Einbringvorgang eines Kabels in die Ausführungsform wie Fig. 2, Kabel vollständig in den inneren Bereich eingebracht,
- Fig. 2d: Entnahmevorgang eines Kabels aus der Ausführungsform wie Fig. 2,
- Fig. 2e: Entnahmevorgang eines Kabels aus der Ausführungsform wie Fig. 2, Kabel vollständig entnommen,
- Fig. 3: eine Ausführungsform der Erfindung mit verschiebbarem Lamellenring,
- Fig. 4: Detailansicht der Lamellen,
- Fig. 5: eine weitere Ausführungsform des Strommessumformers mit Betätigungsabschnitt,
- Fig. 6: eine Ausführungsform des Strommessumformers mit direkt an dem Gehäusebasisabschnitt angeordneten Scharnieren.

### Detaillierte Beschreibung der Figuren

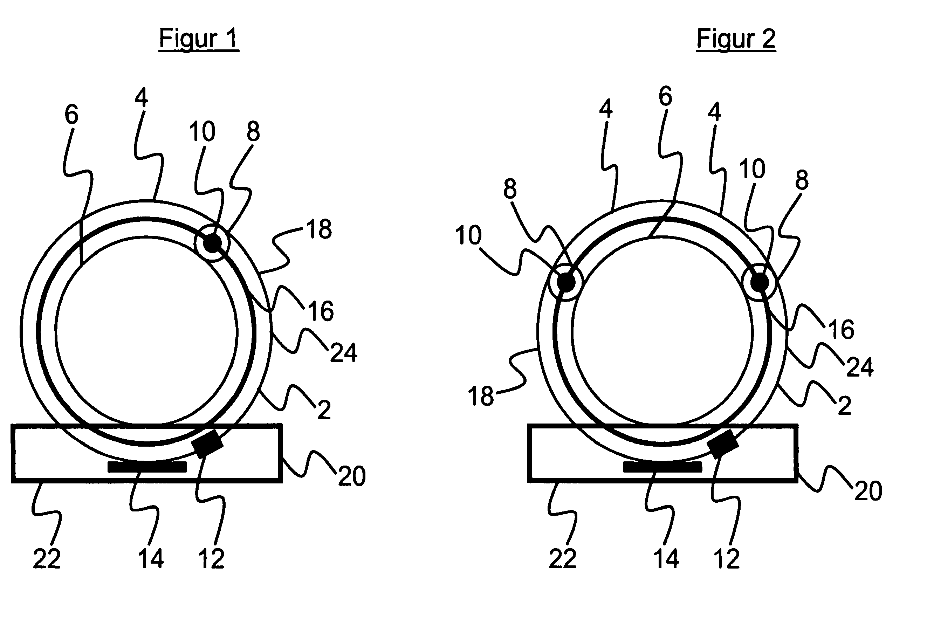

Fig. 1 zeigt eine erste Ausführungsform des induktiven Strommessumformers. Ein Teil des Basisringabschnitts 2 sowie die Auswerteeinrichtung 14 ist in den Gehäusebasisabschnitt 22 eingebettet. Der übrige Teil des Sondenrings 18 wird von einer Umhäusung 24 umschlossen, so dass der gesamte Ringkern 16 eingeschlossen ist. Gehäusebasisabschnitt 22 und Umhäusung 24 bilden zusammen das Gehäuse 20.

Ein Sensor 12 ist am Basisringabschnitt 2 angebracht und typischerweise im Gehäusebasisabschnitt 22 angeordnet. Ein Scharnier 8 mit einem Federelement 10, hier eine Dreh- oder Spiralfeder 10, ist am Basisringabschnitt 2 angeordnet. Mittels des Scharniers 8 kann ein beweglicher Ringabschnitt 4 bewegt werden, wobei die Spiralfeder 10 eine Rückstellkraft auf den beweglichen Ringabschnitt 4 ausübt. Ein radiales Eindrücken von außen an den beweglichen Ringabschnitt 4 bewegt den beweglichen Ringabschnitt 4 von der geschlossenen in die geöffnete Position. Der Einfachheit halber kann das Aufbringen einer radialen Andruckkraft auf den beweglichen Ringabschnitt 4 mit dem einzuführenden Kabel 30 selbst geschehen. Ist das Kabel 30 vollständig in den inneren Bereich des Strommessumformers, insbesondere des Sondenrings 18 eingebracht, so schließt der bewegliche Ringabschnitt 4 selbsttätig, wobei mittels der Spiralfeder 10 der bewegliche Ringabschnitt 4 automatisch zuschnappt, also in den geschlossenen Zustand rücküberführt wird.

Ist ein Kabel 30 in den Strommessumformer eingelegt, und fließt durch das Kabel 30 ein elektrischer Strom, so entsteht in der direkten Umgebung des elektrischen Kabels 30 ein Magnetfeld. Der Sondenring 18, der einen Ringkern 16 umfasst, kann bei geeigneter Wahl der Geometrie des Sondenrings 18 Magnetfeldlinien bündeln. Hierdurch wird die Sensitivität des Strommessumformers erhöht. Eine Strommessung auch bei kleineren elektrischen Leitern und/oder bei geringeren fließenden elektrischen Strömen ist ermöglicht.

Der bewegliche Ringabschnitt 4 ermöglicht dabei das einfache Ein- und Ausführen des elektrischen Kabels 30.

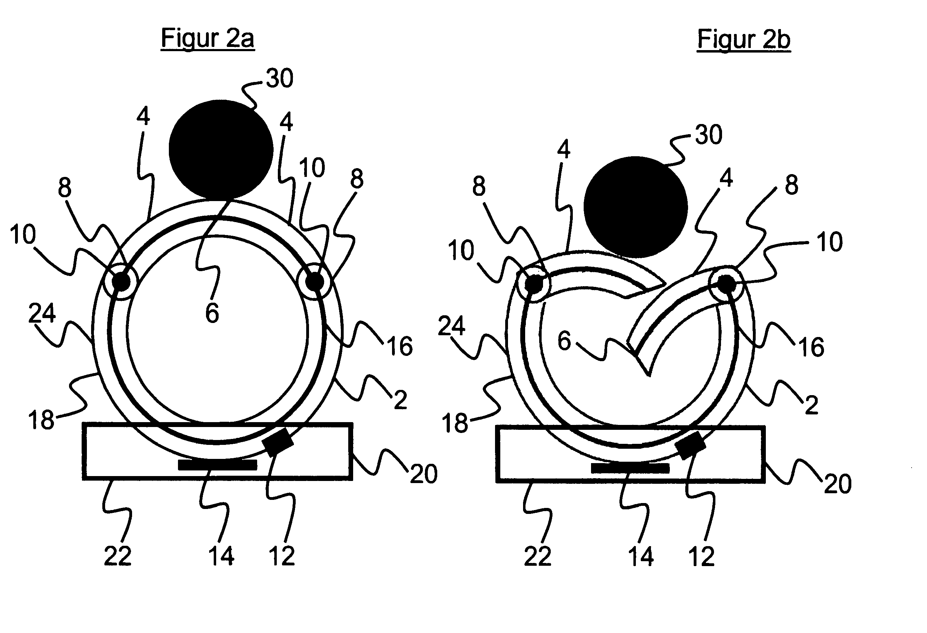

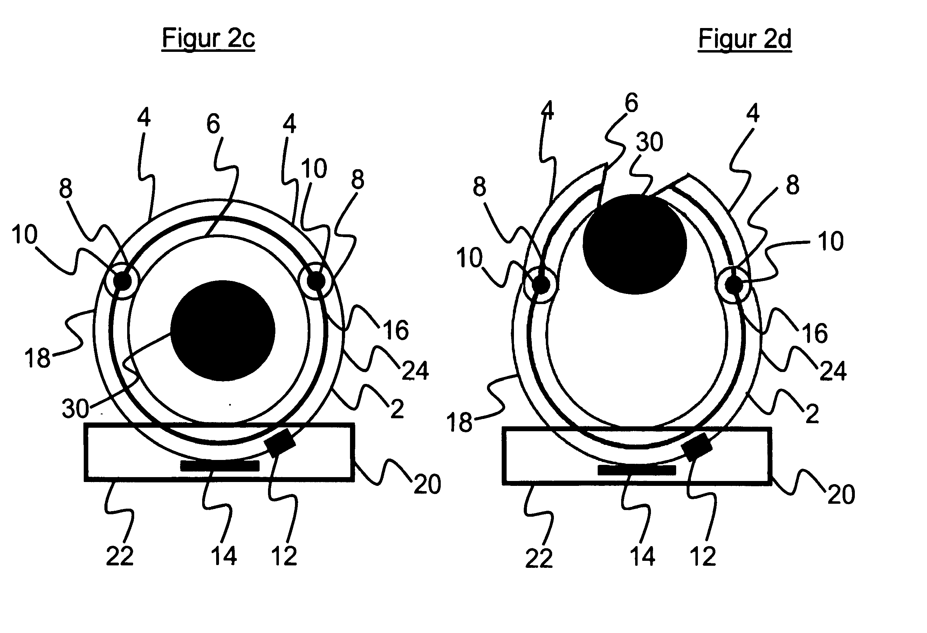

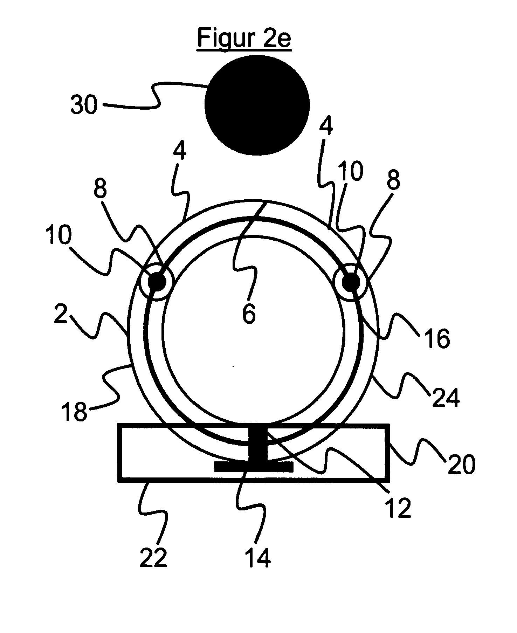

Fig. 2 zeigt eine bevorzugte Ausführungsform der Erfindung. Hierbei sind zwei bewegliche Ringabschnitte 4 mittels Scharnieren 8 radial dreh- bzw. schwenkbar an dem Basisringabschnitt 2 angebracht. Eine Rückstellung der beweglichen Ringabschnitte 4 ist wie in Fig. 1 über in den Scharnieren 8 angeordnete Spiralfedern 10 realisiert. Die Verwendung von zwei beweglichen Ringabschnitten 4 vereinfacht das Ein- und Ausführen des elektrischen Kabels 30, und ermöglicht die Verwendung von größeren Kabeldurchmessern. Alternativ kann dies die Baugröße des gesamten Strommessumformers verringern. Wie in Fig. 1 ist ein Sensor 12 sowie eine Auswerteeinrichtung 14 in einem Gehäuse 20, und dort typischerweise in einem Gehäusebasisabschnitt 22, angeordnet. Der Basisringabschnitt 2 ist an oder im Gehäusebasisabschnitt 22 befestigt.

Figuren 2a bis 2e verdeutlichen das Prinzip des Einbringens eines Kabels 30 in den inneren Bereich des Strommessumformers anhand der in Figur 2 gezeigten Ausführungsform.

Fig. 2a zeigt den Strommessumformer mit von außen angelegtem Kabel 30. Ein radialer Druck, in der Figur 2a aus Richtung oben, lässt die beweglichen Ringabschnitte 4 nach innen aufschwenken, wobei die besondere Ausgestaltung der Trennstelle 6 mittels schräger Stirnseiten der beweglichen Ringabschnitte 4 ein Verhaken der beiden beweglichen Ringabschnitte 4 gegeneinander verhindert.

Fig. 2b zeigt das stückweise einbringen des Kabels 30 in den inneren Bereich des Strommessumformers, wobei die beweglichen Ringabschnitte 4 der radialen Andruckkraft, die mittels des Kabels 30 aufgebracht werden kann, ausweichen und weiter in den inneren Bereich des Strommessumformers schwenken. Die Kabeleinbringöffnung wird hierdurch weiter freigegeben, wobei die Federelemente 10 eine Rückstellkraft in Richtung des geschlossenen Zustands auf die beweglichen Ringelemente 4 aufbauen.

Fig. 2c zeigt das vollständig in den inneren Bereich des Strommessumformers eingebrachte Kabel 30, wobei die beweglichen Ringabschnitte 4 bereits in den geschlossenen Zustand zurückgeschwenkt sind. Mit anderen Worten ist die Kabeleinbringöffnung zugeschnappt, indem die Rückstellkraft der Federelemente 10 die beweglichen Ringabschnitte 4 in den geschlossenen Zustand rücküberführte.

Fig. 2d zeigt den Entnahmevorgang eines Kabels 30 aus dem Strommessumformer. Das radiale Andrücken des Kabels 30 an die beweglichen Ringabschnitte 4 aus Richtung des inneren Bereichs des Strommessumformers lässt die beweglichen Ringabschnitte 4 auseinandergehen, wobei erneut die Federelemente 10 eine Rückstellkraft auf die beweglichen Ringabschnitte 4 ausüben. Mit anderen Worten wird das Kabel 30 aus dem inneren Bereich gegen die Rückstellkraft der Federelemente 10 an die beweglichen Ringabschnitte 4 angedrückt und damit die Kabeleinbringöffnung freigegeben.

Fig. 2e zeigt das vollständig aus dem Strommessumformer entnommene Kabel 30. Die beweglichen Ringabschnitte sind erneut mittels der Rückstellkraft der Federelemente 10 automatisch in den geschlossenen Zustand geschnappt.

Des Weiteren zeigt Fig. 2e einen alternativen Anbringungsort für den Sensor 12. Insbesondere wenn der Sensor 12 ein Hall-Sensor 12 ist, wird dieser an einer Trennstelle im Ringkern 16 angeordnet, damit der Magnetfluss durch den Ringkern 16 auch durch den Hall-Sensor 12 strömt.

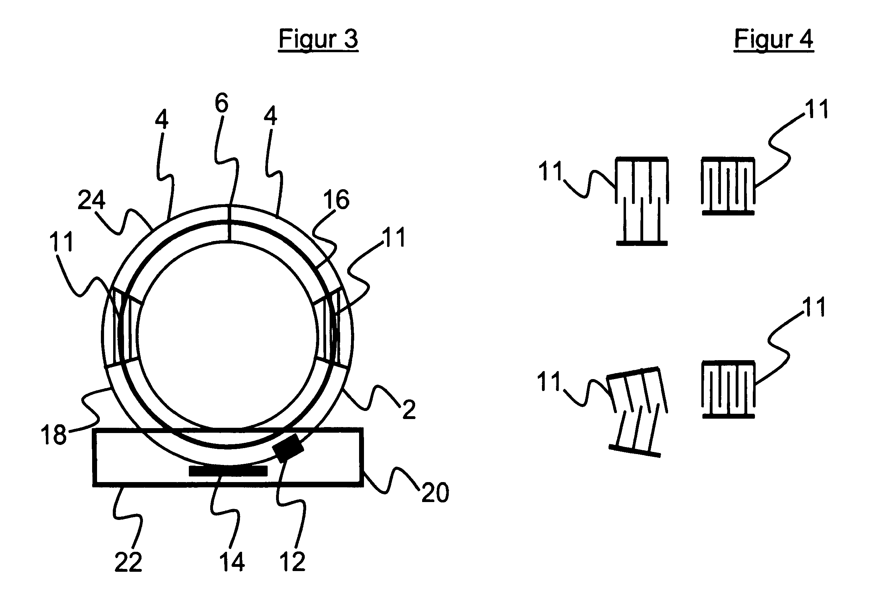

Fig. 3 zeigt eine weitere Ausführungsform der Erfindung. Hierbei weist der Sondenring 18 zwei bewegliche Ringabschnitte 4 auf, welche tangential zum Sondenringumfang verschiebbar sind. Der Ringkern 16 weist ineinandergreifende Lamellen 11 auf, um damit trotz der verschiebbaren Ausgestaltung des Sondenrings 18 den Magnetfluss durch den Ringkern 16 aufrechtzuerhalten. Das Aufbringen einer radialen Andruckkraft auf die beweglichen Ringabschnitte 4 überführt die beweglichen Ringabschnitte 4 analog der Beschreibung der vorherigen Figuren von dem geschlossenen in den geöffneten Zustand, indem die ineinandergreifenden Lamellen 11 zusammengeschoben werden und somit eine Kabeleinbringöffnung freigeben. Die Rückstellung in den geschlossenen Zustand geschieht automatisch mittels Federelementen 10, die zwischen oder an den ineinandergreifenden Lamellen 11 angeordnet sind, sobald das Kabel vollständig in den inneren Bereich des Strommessumformers eingebracht ist. Dieser Ausführungsform der Erfindung ist vorteilhaft, dass keine in den zu öffnenden Bereich oder den Außenbereich des Strommessumformers ragenden Teile verbaut sind. Dennoch werden mittels des Schiebeöffnungsmechanismus keine den Magnetfluss störenden fremden Werkstoffe in den Sondenring 18 verbaut, wodurch die Sensitivität des Strommessumformers weiter erhöht werden kann. Die ineinandergreifenden Lamellen 11 können daher als Teil des Ringkerns angesehen werden.

Fig. 4 zeigt eine Detailansicht der in Fig. 3 verwendeten ineinandergreifenden Lamellen. Die jeweils linke Darstellung zeigt die geschlossene Anordnung der beweglichen Ringabschnitte, die jeweils rechte Darstellung zeigt die geöffnete Stellung. Hierbei werden die ineinandergreifenden Lamellen zusammengedrückt, wodurch ein Ringabschnitt freigegeben wird.

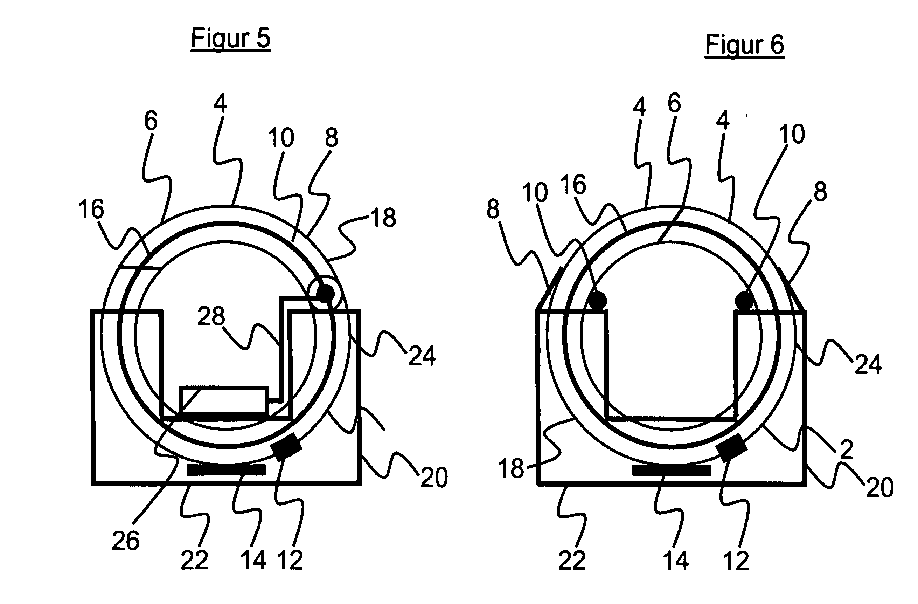

Fig. 5 zeigt einen Strommessumformer mit einem beweglichen Ringabschnitt 4 und einem Betätigungsabschnitt 26. Der bewegliche Ringabschnitt 4 wird zunächst geöffnet, und verrastet in einer geöffneten Stellung, wobei eine Rückstellkraft mittels einer Spiralfeder 10, die in dem Scharnier 8 angeordnet ist, auf den beweglichen Ringabschnitt wirkt. Beim Einlegen des elektrischen Kabels in den inneren Bereich des Strommessumformers, wird der Betätigungsabschnitt 26 durch das Kabel mittels Andrücken betätigt. Eine Wirkverbindung 28 zwischen dem Betätigungsabschnitt 26 und dem Scharnier 8, beispielsweise ein Gelenk oder eine andere flexible Verbindung, öffnet die Verrastung des beweglichen Ringabschnitts 4 und überführt den beweglichen Ringabschnitt 4 automatisch in den geschlossenen Zustand. Wird diese Ausführungsform der Erfindung bereits in dem geöffneten Zustand ausgeliefert, so ist ein besonders einfaches Einbringen des elektrischen Kabels in den inneren Bereich des Strommessumformers ermöglicht. Zum vollständigen und automatischen Schließen des beweglichen Ringabschnitts ist lediglich der Betätigungsabschnitt 26 mit dem elektrischen Kabel mit einer Andruckkraft zu beaufschlagen. Gegebenenfalls verrastet beim Schließen des Strommessumformers der bewegliche Ringabschnitt 4 an dem Basisringabschnitt 2 des Sondenrings 18, so dass ein Öffnen für den dafür nicht qualifizierten Anwender erschwert ist. Diese Verrastung kann an der Trennstelle 6 angeordnet sein.

Allen Ausführungsformen ist gleich, dass eine möglichst kreisförmig geschlossene Anordnung im geschlossenen Zustand entsteht. Eine solche Anordnung ist in Anlehnung des das elektrische Kabel umgebende magnetischen Feldes besonders geeignet für eine sensitive Messung des das elektrische Kabel durchfließenden elektrischen Stromes.

Der in dem Sondenring angeordnete kreisförmige Ringkern 16 bündelt dieses magnetische Feld, und verstärkt so dessen Messbarkeit. Mittels des Sensors 12 wird die Feldstärke im Ringkern gemessen. Mittels der Auswerteeinrichtung 14 wird der am Sensor 12 erhaltene Wert in eine ablesbare Größe übertragen. Dies kann ein Digitalwert sein, aber auch eine analoge Spannungsgröße ist möglich. Auch eine direkte Auswertung in dem Strommessumformer ist möglich, eine Übertragung der erhaltenen Werte ist beispielsweise über eine drahtlose Kommunikationsverbindung ermöglicht.

Die Anordnung mit einem beweglichen Ringabschnitt ermöglicht in besonders einfacher Weise auch das nachträgliche Anbauen eines Strommessumformers an eine bereits installierte elektrische Leitung.

Der Sensor 12 ist insbesondere ein Hall-Sensor zur Messung des Magnetfelds im Ringkern des Sondenrings. Zur Anordnung des Hall-Sensors 12 in dem Sondenring 18 befindet sich im Ringkern 16 im Bereich des Gehäusebasisabschnitts 22 ein Spalt im Ringkern 16, in welchen der Hall-Sensor 12 eingesetzt wird.

Der Sensor 12 ist insbesondere auch ein magneto-resistiver Sensor, der in dem Sondenring angeordnet ist. Der magneto-resistive Sensor 12 ist an dem Ringkern 16 vorzugsweise im Bereich des Gehäusebasisabschnitts 22 unmittelbar an dem Ringkern 16 angeordnet. Der Sensor 12, insbesondere der Hall-Sensor 12 oder der magneto-resistive Sensor 12, ist direkt mit der Auswerteeinrichtung 14 verbunden. Auch bei der Verwendung eines magneto-resistiven Sensors 12 ist die Verwendung eines Ringkerns 16 im Sondenring 18 vorteilhaft, da auch dieses Messverfahren das magnetische Feld um das elektrische Kabel zur Messung heranzieht.

Fig. 6 zeigt schließlich eine Ausführungsform der Erfindung, bei der das Scharnier 8 an oder im Gehäusebasisabschnitt 22 angeordnet ist. Die Anbringung des Scharniers 8 außerhalb des Sondenrings 18 ermöglicht das Freihalten des Ringkerns 16 von das Magnetfeld störenden anderen Werkstoffen, die für das Anbringen des Scharniers 8 ggfs. benötigt werden. Das Scharnier 8 der in Fig. 6 gezeigten Ausführungsform ist demnach außerhalb des Sondenrings 18, zumindest und in jedem Fall aber außerhalb des Ringkerns 16, angeordnet. Das Federelement 10 zur Erzeugung einer Rückstellkraft auf das bewegliche Ringelement 4 ist dabei an dem Gehäuse 20, insbesondere an dem Gehäusebasisabschnitt 22, angebracht. Das Einbringen des elektrischen Kabels 30 in den inneren Bereich des Strommessumformers überführt auch hier den beweglichen Ringabschnitt 4 von dem geschlossenen in den geöffneten Zustand. Hat das elektrische Kabel 30 den beweglichen Ringabschnitt 4 vollständig passiert, und ist damit in den inneren Bereich des Sondenrings 18 des Strommessumformers eingebracht, so wird der bewegliche Ringabschnitt 4 mittels des Federelements 10 automatisch in den geschlossenen Zustand rücküberführt, es schnappt zu.

Es ist dem Fachmann ersichtlich, dass die vorstehend beschriebenen Ausführungsformen beispielhaft zu verstehen sind und die Erfindung nicht auf diese beschränkt ist, sondern in vielfältiger Weise variiert werden kann, ohne die Erfindung zu verlassen. Ferner ist ersichtlich, dass die Merkmale unabhängig davon, ob sie in der Beschreibung, den Ansprüchen, den Figuren oder anderweitig offenbart sind, auch einzeln wesentliche Bestandteile der Erfindung definieren können, selbst wenn sie zusammen mit anderen Merkmalen gemeinsam beschrieben sind.

### Bezugszeichenliste

- 2: Basisringabschnitt
- 4: Beweglicher Ringabschnitt
- 6: Trennstelle des Ringabschnitts
- 8: Scharnier
- 10: Federelement
- 11: Lamellenelement
- 12: Sensor
- 14: Auswerteeinrichtung
- 16: Ringkern
- 18: Sondenring
- 20: Gehäuse
- 22: Gehäusebasisabschnitt
- 24: Umhäusung des Ringkerns
- 26: Betätigungsabschnitt
- 28: Wirkverbindung
- 30: Kabel

## Patentansprüche

1. Strommessumformer zum Messen des durch ein elektrisches Kabel fließenden Stroms,
mit einem Sondenring (18) und einer Auswerteeinrichtung (14),
wobei der Sondenring einen Ringkern (16) umfasst,
wobei der Sondenring in einen Basisringabschnitt (2) und zumindest einen beweglichen Ringabschnitt (4) unterteilt ist,
wobei das radiale Einbringen des sich axial zum Strommessumformer erstreckenden Kabels in den inneren Bereich des Sondenrings (18) den beweglichen Ringabschnitt (4) automatisch von einem geöffneten Zustand in einen geschlossenen Zustand überführt, und in dem geschlossenen Zustand die Strommessung an dem in den inneren Bereich eingebrachten Kabel ermöglicht ist
**gekennzeichnet durch**
einen magnetoresistiven Sensor (12),
wobei die Auswerteeinrichtung (14) hergerichtet ist zur Berechnung der mit dem magnetoresistiven Sensor (12) erhaltenen Messwerte,
wobei der bewegliche Ringabschnitt den geöffneten und den geschlossenen Zustand definiert, und
wobei in dem geöffneten Zustand eine radiale Kabeleinführöffnung freigegeben ist, wobei sich im geschlossenen Zustand des beweglichen Ringabschnitts (4) eine kreisförmig geschlossene Anordnung ergibt, in der der Ringkern (16) das Kabel kreisförmig umschließt .

2. Strommessumformer nach vorstehendem Anspruch, wobei der Strommessumformer ein Federelement (10) umfasst, welches in dem geschlossenen Zustand den beweglichen Ringabschnitt (4) gegen den Basisringabschnitt (2) federnd vorspannt, wobei mittels Beaufschlagung einer radialen Druckkraft auf den beweglichen Ringabschnitt (4) der bewegliche Ringabschnitt (4) gegen die Federvorspannung geöffnet wird und selbsttätig schließt, wenn das Kabel vollständig radial in den inneren Bereich eingebracht ist.

3. Strommessumformer nach Anspruch 1,
mit einem im inneren Bereich des Strommessumformers angeordneten Betätigungsabschnitt (26),
wobei der Strommessumformer sowohl im geöffneten als auch im geschlossenen Zustand selbsthaltend ausgebildet ist,
wobei der bewegliche Ringabschnitt (4) im geöffneten Zustand die Kabeleinführöffnung freigibt und der bewegliche Ringabschnitt mittels Beaufschlagung einer radialen Druckkraft auf den Betätigungsabschnitt unter Überwindung der Selbsthaltekraft selbsttätig schließt, sobald das Kabel vollständig radial in den inneren Bereich eingebracht und der Betätigungsabschnitt (26) betätigt ist.

4. Strommessumformer nach einem der vorstehenden Ansprüche,
wobei der Sondenring (18) ein Scharnier (8) umfasst, welches zwischen dem Basisringabschnitt (2) und dem beweglichen Ringabschnitt (4) angeordnet ist, derart dass der bewegliche Ringabschnitt (4) mittels des Scharniers (8) quer zur Kabelachse schwenkbar gelagert ist.

5. Strommessumformer nach vorstehendem Anspruch,
wobei das Scharnier (8) derart ausgebildet ist, dass der bewegliche Ringabschnitt (4) mittels des Scharniers (8) quer zur Kabelachse nach innen schwenkbar gelagert ist.

6. Strommessumformer nach einem der Ansprüche 1 bis 3,
wobei der bewegliche Ringabschnitt (4) entlang des Sondenringumfangs verschiebbar ausgebildet ist und das Beaufschlagen einer radialen Druckkraft auf den beweglichen Ringabschnitt (4) den beweglichen Ringabschnitt in die geöffnete Position verschiebt.

7. Strommessumformer nach einem der vorstehenden Ansprüche,
wobei der Sondenring (18) zwei symmetrisch zueinander ausgebildete bewegliche Ringabschnitte (4) umfasst,
wobei die beweglichen Ringabschnitte (4) im geöffneten Zustand die radiale Kabeleinführöffnung zwischen den beweglichen Ringabschnitten freigeben.

8. Strommessumformer nach vorstehendem Anspruch, wobei der Strommessumformer zwei Federelemente (10) umfasst, welche in dem geschlossenen Zustand die beweglichen Ringabschnitte (4) gegeneinander federnd vorspannen, so dass mittels Beaufschlagung einer radialen Druckkraft auf die beweglichen Ringabschnitte (4) die Kabeleinführöffnung freigegeben wird und, wenn das Kabel vollständig radial in den inneren Bereich eingebracht ist, die beweglichen Ringabschnitte mittels der Federn in den geschlossenen Zustand überführt werden.

9. Strommessumformer nach einem der vorstehenden Ansprüche, ferner umfassend
ein dielektrisches Gehäuse (20) zur Beherbergung der Auswerteeinrichtung (14), des magnetoresistiven Sensors (12) und des Ringkerns (16) und/oder mit Mitteln zum Befestigen des Gehäuses (20).

## Claims

1. A current measuring transducer for measuring the current flowing through an electrical cable,
with a ring probe (18) and an evaluation device (14), wherein the ring probe contains an annular core (16), wherein the ring probe is divided into a basic ring section (2) and at least one movable ring section (4),
wherein radial insertion of the cable extending axially to the current measuring transducer into the inside area of the ring probe (18) automatically transfers the movable ring section (4) from an open state to a closed state and, in the closed state, measurement of the current in the cable inserted into the inside area is made possible
**characterized in**
a magnetoresistive sensor (12),
wherein the evaluation device (14) is designed for calculating the measurement values obtained by the magnetoresistive sensor (12),
wherein the movable ring section defines the open and the closed state, and
wherein in the open state a radial cable insert opening is opened, wherein in the closed state of the movable ring section (4) a circularly closed arrangement is created in which the annular core (16) surrounds the cable circularly.

2. The current measuring transducer of the preceding claim,
wherein the current measuring transducer contains a spring element (10) which in the closed state creates a spring tension of the movable ring section (4) against the basic ring section (2), wherein, by application of radial pressure upon the movable ring section (4), said movable ring section opens against the spring tension and automatically closes when the cable is radially inserted completely into the inside area.

3. The current measuring transducer of claim 1,
with an actuation section (26) arranged in an inside area of the current measuring transducer,
wherein the current measuring transducer is constructed to be locking in the open state as well as the closed state,
wherein the movable ring section (4) opens the cable insert opening in the open state and the movable ring section closes automatically by exertion of radial pressure on the actuating section by overcoming the locking force as soon as the cable is inserted into the inside area and the actuating section (26) is activated.

4. The current measuring transducer of one of the preceding claims,
wherein the ring probe (18) contains a hinge (8) arranged between the basic ring section (2) and the movable ring section (4), such that the movable ring section (4) is pivotable transversely to the cable axis by the hinge (8).

5. The current measuring transducer of the preceding claim,
wherein the hinge (8) is constructed in such a manner that the movable ring section (4) is arranged to pivot inward transversely to the cable axis by the hinge (8).

6. The current measuring transducer of one of claims 1 to 3,
wherein the movable ring section (4) is designed to slide along the circumference of the ring probe and the exertion of radial pressure on the movable ring section (4) slides the movable ring section into the open position.

7. The current measuring transducer of one of the preceding claims,
wherein the ring probe (18) contains two movable ring sections (4) constructed symmetrically to each other,
wherein the movable ring sections (4) in the open state open the radial cable insert opening between the movable ring sections.

8. The current measuring transducer according to the preceding claim,
wherein the current measuring transducer contains two spring elements (10) that exert spring tension on the movable ring sections (4) against each other in the closed state so that the cable insert opening is opened by the exertion of radial pressure on the movable ring sections (4) and, when the cable is radially inserted completely into the inside area, the movable ring sections are transferred into the closed state by the springs.

9. The current measuring transducer of one of the preceding claims, further comprising
a dielectric housing (20) for containing the evaluation device (14), the magnetoresistive sensor (12) and the annular core (16) and/or having means for fastening the housing (20).

## Revendications

1. Convertisseur de mesure de courant, destiné à mesurer le courant passant dans un câble électrique,
comprenant une bague de détection (18) et un dispositif d'évaluation (14),
sachant que la bague de détection comporte un noyau toroïdal (16),
sachant que la bague de détection est divisée en une partie de bague de base (2) et au moins une partie de bague (4) mobile,
sachant que l'introduction radiale du câble, s'étendant axialement par rapport au convertisseur de mesure de courant, dans la zone interne de la bague de détection (18), fait passer la partie de bague (4) mobile automatiquement d'un état ouvert à un état fermé, et qu'à l'état fermé la mesure de courant sur le câble amené dans la zone interne est possible,
**caractérisé en ce qu'**il comporte un capteur magnétorésistif (12),
sachant que le dispositif d'évaluation (14) est agencé pour le calcul des valeurs mesurées obtenues avec le capteur magnétorésistif (12),
sachant que la partie de bague mobile définit l'état ouvert et fermé,
sachant qu'à l'état ouvert, une ouverture d'introduction de câble radiale est dégagée, sachant qu'à l'état fermé de la partie de bague (4) mobile, il en résulte une disposition circulaire fermée, dans laquelle le noyau toroïdal (6) entoure le câble sous une forme circulaire.

2. Convertisseur de mesure de courant selon la revendication précédente,
sachant que le convertisseur de mesure de courant comprend un élément faisant ressort (10) qui, à l'état fermé, met la partie de bague (4) mobile sous précontrainte élastique contre la partie de bague de base (2), sachant qu'au moyen de l'application d'une force de pression radiale à la partie de bague (4) mobile, la partie de bague (4) mobile est ouverte à l'encontre de la précontrainte élastique et se ferme automatiquement lorsque le câble est introduit complètement radialement dans la zone interne.

3. Convertisseur de mesure de courant selon la revendication 1,
comprenant une partie d'actionnement (26) disposée dans la zone interne du convertisseur de mesure de courant,
sachant que le convertisseur de mesure de courant est réalisé avec auto-maintien, aussi bien à l'état ouvert qu'à l'état fermé,
sachant qu'à l'état ouvert, la partie de bague (4) mobile dégage l'ouverture d'introduction de câble, et la partie de bague mobile se ferme automatiquement au moyen de l'application d'une force de pression radiale à la partie d'actionnement, en surmontant la force d'auto-maintien, dès que le câble est introduit complètement radialement dans la zone interne et que la partie d'actionnement (26) est actionnée.

4. Convertisseur de mesure de courant selon l'une des revendications précédentes,
sachant que la bague de détection (18) comprend une charnière (8) qui est placée entre la partie de bague de base (2) et la partie de bague (4) mobile, de telle sorte que la partie de bague (4) mobile soit montée au moyen de la charnière (8) avec possibilité de pivotement, transversalement à l'axe de câble.

5. Convertisseur de mesure de courant selon la revendication précédente,
sachant que la charnière (8) est agencée de telle sorte que la partie de bague (4) mobile soit montée au moyen de la charnière (8) avec possibilité de pivotement vers l'intérieur, transversalement à l'axe du câble.

6. Convertisseur de mesure de courant selon l'une des revendications 1 à 3,
sachant que la partie de bague (4) mobile est réalisée de manière à pouvoir être déplacée le long de la circonférence de la bague de détection, et l'application d'une force de pression radiale à la partie de bague (4) mobile déplace la partie de bague mobile à la position ouverte.

7. Convertisseur de mesure de courant selon l'une des revendications précédentes,
sachant que la bague de détection (18) comprend deux parties de bague (4) mobiles réalisées de façon symétrique l'une par rapport à l'autre,
sachant qu'à l'état ouvert, les parties de bague (4) mobiles dégagent l'ouverture d'introduction de câble radiale entre les parties de bague mobiles.

8. Convertisseur de mesure de courant selon la revendication précédente,
sachant que le convertisseur de mesure de courant comprend deux éléments faisant ressort (10) qui, à l'état fermé, mettent sous précontrainte élastique, l'une contre l'autre, les parties de bague (4) mobiles, de sorte qu'au moyen de l'application d'une force de pression radiale aux parties de bague (4) mobiles, l'ouverture d'introduction de câble soit dégagée et, lorsque le câble est introduit complètement radialement dans la zone interne. les parties de bague (4) mobiles sont amenées à l'état fermé au moyen des ressorts.

9. Convertisseur de mesure de courant selon l'une des revendications précédentes, comprenant en outre
un boîtier (20) diélectrique destiné à loger le dispositif d'évaluation (14), du capteur magnétorésistif (12) et du noyau toroïdal (16) et/ou avec des moyens pour fixer le boîtier (20) .
